## Europäisches Patentamt
(19) **European Patent Office**

**Office européen des brevets**

(11) Numéro de publication: **0 040 125**
**B1**

(12) # FASCICULE DE BREVET EUROPEEN

(45) Date de publication du fascicule du brevet:
30.11.83

(51) Int. Cl.³: **H 01 L  27/02,** H 01 L  29/06,
H 01 L  21/76

(21) Numéro de dépôt: **81400665.6**

(22) Date de dépôt: **28.04.81**

---

(54) **Dispositif de protection contre les courants de fuite dans des circuits intégrés.**

---

(30) Priorité: **14.05.80  FR 8010842**

(43) Date de publication de la demande:
**18.11.81 Bulletin 81/46**

(45) Mention de la délivrance du brevet:
**30.11.83 Bulletin 83/48**

(84) Etats contractants désignés:
**DE FR GB IT NL**

(56) Documents cités:
**CH - A - 506 889**
**FR - A - 2 113 906**
**FR - A - 2 303 382**
**US - A - 3 590 345**

**ELECTRONICS, vol. 48, no. 15, 24 juillet 1975, NEW YORK (US) "Buried moat stops negative swings" pages 31,32**

(73) Titulaire: **THOMSON-CSF, 173, Boulevard Haussmann, F-75379 Paris Cedex 08 (FR)**

(72) Inventeur: **Van Zanten, François, THOMSON-CSF SCPI 173, bld Haussmann, F-75360 Paris Cedex 08 (FR)**

(74) Mandataire: **de Beaumont, Michel et al, THOMSON-CSF SCPI 173, Bld Haussmann, F-75379 Paris Cedex 08 (FR)**

---

## Dispositif de protection contre les courants de fuite dans des circuits integres

La présente invention concerne un dispositif de protection contre les courants de fuite dans les circuits intégrés monolithiques, ces courants de fuite étant provoqués par des surtensions parasites inverses.

Dans la description qui suit, on se référera à des circuits intégrés bipolaires à substrat de type P et couche épitaxiée de type N. Bien entendu, la présente invention s'applique également au cas où les types de conductivité des diverses couches sont tous inversés.

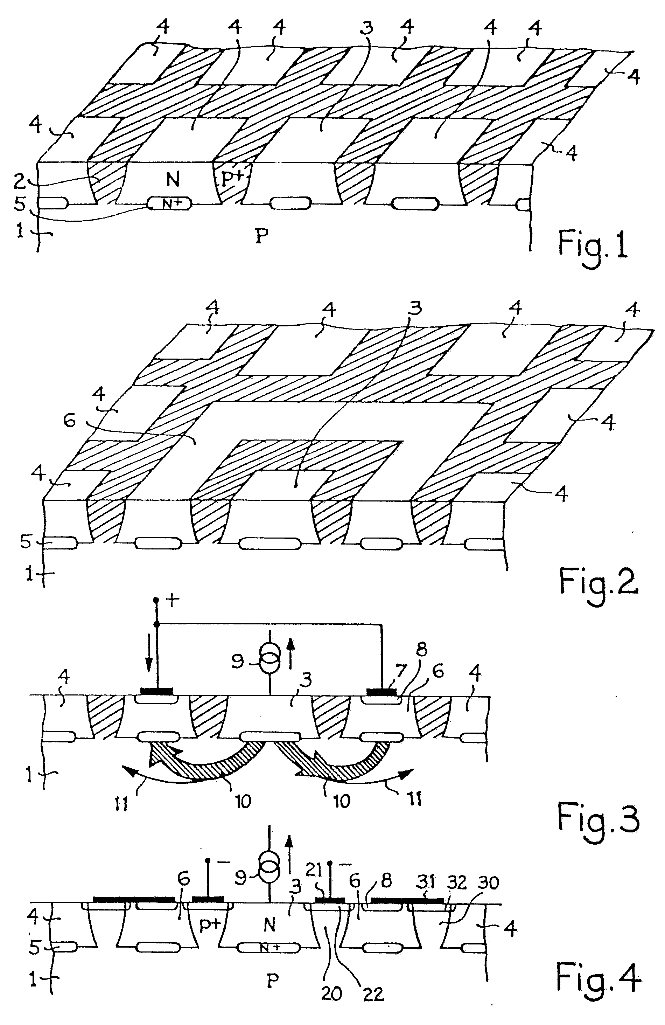

La figure 1 représente de façon partielle et très schématique une portion d'un circuit intégré bipolaire classique en vue en perspective et en coupe. Ce circuit est élaboré sur un substrat 1 de type P sur lequel est formé une couche épitaxiée de type N divisée en caissons par des murs d'isolement 2 de type P+. A l'intérieur de chacun des caissons est formé un composant particulier, par exemple un transistor NPN ou PNP, qui se trouve isolé de ses voisins par les murs d'isolement 2. Bien entendu, pour que le fonctionnement des composants situés à l'intérieur de chacun des caissons soit indépendant de celui des composants voisins, il convient que la polarité entre les caissons et le substrat liée à la tension d'alimentation soit telle que la jonction NP entre chaque caisson et le substrat soit bloquée. Ainsi, le substrat doit être polarisé plus négativement que chacun des caissons. Néanmoins, en raison de l'environnement et des connexions externes des composants situés dans les caissons, il se peut que l'un d'eux, par exemple le caisson 3, reçoive des tensions parasites plus négatives que la tension de polarisation du substrat. Alors, la jonction NP entre ce caisson et le substrat se trouvera débloquée et des électrons pourront être injectés dans le substrat. Ces électrons seront susceptibles de diffuser dans le substrat et seront collectés par les caissons environnants, désignés collectivement par la référence 4, d'où il pourra résulter l'apparition de courants de fuite dans les composants situés dans ces caissons environnants 4. Bien entendu, ce seront les caissons les plus immédiatement voisins du caisson parasité qui seront les plus susceptibles d'être affectés. Dans la figure 1, on a également représenté des couches enterrées 5 de type N+ au fond de chacun des caissons 3 et 4, comme cela est classique dans la technologie des circuits intégrés bipolaires. Une autre façon de considérer les courants de fuite apparaissant dans des caissons 4 voisins d'un caisson 3 soumis à des surtensions négatives consiste à dire que ces courant de fuite résultent de la circulation de courant entre émetteur et collecteurs d'un transistor latéral multicollecteurs dont l'émetteur est constitué par le caisson 3 éventuellement soumis à une surtension négative parasite, dont la base est constituée par le substrat 1, et dont les collecteurs sont constitués par les divers caissons 4.

Dans l'art antérieur, pour tenter de résoudre ce problème de contamination des caissons voisins d'un caisson éventuellement soumis à différentes tensions négatives, on a adopté la structure schématiquement représentée en figures 2 et 3. Autour du caisson 3 susceptible de recevoir des tensions négatives parasites, est prévu un caisson annulaire 6 qui entoure au moins partiellement le caisson 3, et est interposé entre le caisson 3 et les caissons 4 que l'on veut protéger. Comme le montre la figure 3, une métallisation 7 est déposée sur le caisson annulaire 6, avec interposition, comme cela est usuel, d'une couche 8 à niveau de dopage élevé et de même type de conductivité que celui du caisson 6 permettant d'assurer l'ohmicité du contact. Cette métallisation annulaire 7 est connectée à la borne d'alimentation positive du circuit intégré. Ainsi, si une surtension parasite, représentée sous la forme d'une source de courant 9 tendant à faire sortir du courant du caisson 3, est appliquée, il en résulte une injection d'électrons dans le substrat. Cette injection d'électrons est désignée par la flèche de forte épaisseur 10. Les électrons 10 ont tendance à être collectés par le caisson 6 puis sont renvoyés par la métallisation 7 et la connexion associée vers l'alimentation positive. Si l'on s'intéresse non plus au sens de conduction des électrons mais à la direction classique de passage de courant, on peut dire qu'un courant circule depuis la borne d'alimentation positive à travers le caisson annulaire 6, le substrat 1 et le caisson 3 vers la source de courant 9. Par ce procédé, une grande partie des électrons diffusant dans le substrat 1 sont collectés par le caisson annulaire 6. Néanmoins, une faible partie de ces électrons symbolisés par la flèche de faible épaisseur 11 continue à diffuser dans le substrat vers les caissons environnants 4 dans lesquels un courant de fuite est créé. Dans la pratique, la demanderesse a observé que seulement 9/10e du courant de fuite total est absorbé par le caisson annulaire 6 et qu'il demeure encore sensiblement 1/10e du courant injecté par la source de courant 9 qui contribue à la fuite des caissons 4. D'autre part, le courant prélevé sur l'alimentation positive de la source d'alimentation du circuit intégré contribue à accroître la puissance dissipée dans celui-ci. Pour remédier à ce dernier inconvénient, il est également possible de relier la métallisation du caisson annulaire à la masse, ce qui réduit la puissance dissipée dans le circuit intégré mais réduit également l'efficacité de collection de ce caisson annulaire.

Ainsi, un objet de la présente invention est de prévoir un nouveau type de dispositif de protection contre les courants de fuite dans un circuit intégré présentant de meilleurs résultats que les moyens employés dans l'art antérieur.

Notamment, un objet de la présente invention est de prévoir un tel dispositif de protection n'entraînant pas de dissipation de puissance dans le circuit intégré.

Un autre objet de la présente invention est de prévoir un dispositif de protection réduisant les courants de fuite d'un facteur de $10^5$ à $10^7$ et non pas simplement de 10 comme les moyens de l'art antérieur.

Pour atteindre ces objets ainsi que d'autres, la présente invention prévoit, comme cela était déjà connu, d'entourer un caisson susceptible d'être parasité d'un caisson annulaire. Mais, au lieu de relier ce caisson annulaire à la borne d'alimentation positive du circuit intégré, ce caisson annulaire est connecté à son mur d'isolement externe correspondant. D'autre part, le mur d'isolement séparant le caisson parasité du caisson annulaire est connecté au potentiel le plus négatif de la tension d'alimentation.

Comme on le verra dans la description détaillée ci-après de modes de réalisation particuliers de la présente invention, quand on réalise les connexions indiquées ci-dessus, le caisson annulaire n'a plus la même fonction que celui de l'art antérieur et la protection des caissons voisins du caisson susceptible d'être parasité est assurée par la création d'un champ électrique s'opposant à la diffusion des électrons engendrés au voisinage de la jonction entre le caisson parasité et le substrat.

Ces objets, caractéristiques et avantages ainsi que d'autres de la présente invention seront exposés plus en détail dans la description suivante de modes de réalisation particuliers, faite en relation avec les figures jointes parmi lesquelles:

les figures 1 à 3 qui étaient destinées à poser le problème résolu par la présente invention et à exposer les solutions partielles de l'art antérieur ont été décrites précédemment;

la figure 4 est une vue en coupe schématique illustrant la présente invention;

la figure 5 est une vue en coupe schématique destinée à servir de support à un exposé théorique sur le fonctionnement de la structure selon la présente invention;

les figures 6 et 7 sont des courbes illustrant les résultats obtenus par l'utilisation de la structure selon la présente invention.

Dans ces diverses figures, on notera que, conformément à l'usage dans le domaine des semiconducteurs, les diverses couches et zones semiconductrices ne sont pas représentées à l'échelle ni d'une figure à l'autre ni à l'intérieur d'une même figure mais sont uniquement tracées dans un but illustratif. D'autre part, dans les diverses figures, des références identiques désignent des zones, couches ou composants analogues.

La figure 4 représente une vue en coupe d'une structure selon la présente invention. Cette vue en coupe correspond à la vue de dessus de la figure 2, c'est-à-dire que le caisson 3, susceptible de recevoir des tensions parasites négatives est entouré d'un caisson annulaire 6 pour protéger les caissons voisins 4. La différence entre la présente invention telle qu'elle est représentée schématiquement en figure 4 et les dispositifs de l'art antérieur tels qu'ils sont schématiquement représentés en figure 3 réside essentiellement dans les métallisations et connexions des diverses couches. Selon la présente invention, le mur d'isolement 20 séparant le caisson 3 du caisson annulaire 6 est recouvert d'une métallisation 21 connectée à la borne d'alimentation la plus négative du circuit. Une zone surdopée 22 de type $P^+$ est prévue si nécessaire pour améliorer l'ohmicité du contact entre la métallisation 21 et la surface du mur d'isolement 20. D'autre part, si l'on désigne par la référence 30 le mur d'isolement externe au caisson annulaire 6, la surface apparente de ce mur d'isolement est reliée par une métallisation 31 à la surface apparente du caisson annulaire 6. Comme dans le cas de la figure 3, une couche surdopée 8 assure l'ohmicité du contact entre le caisson 6 et la métallisation 31. De même, une zone surdopée 32 assure si nécessaire l'ohmicité du contact entre la métallisation 31 et la surface du mur d'isolement 30.

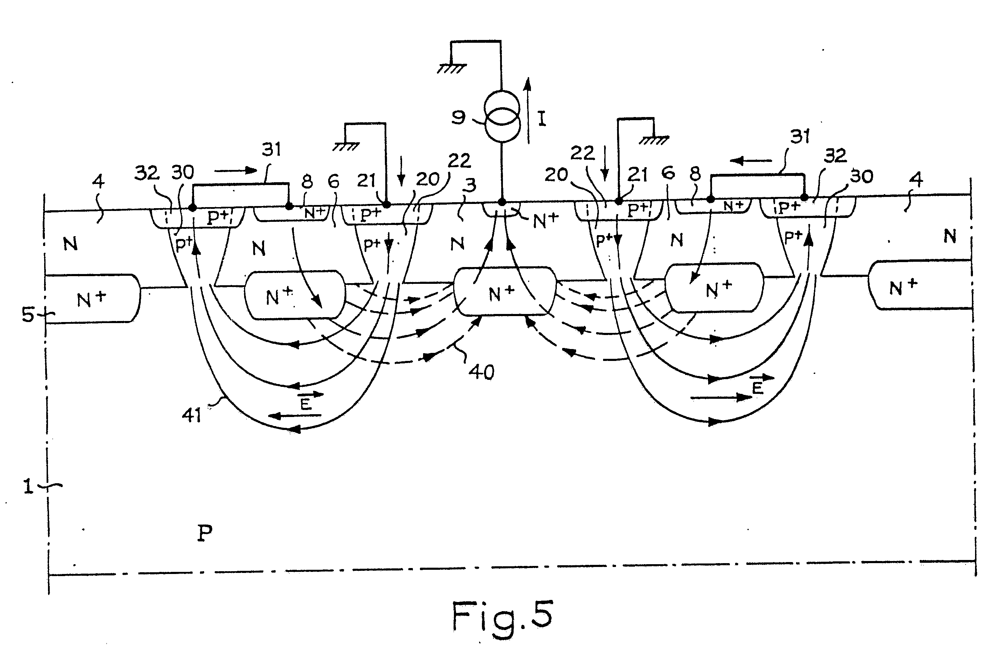

La figure 5 reprend sensiblement la figure 4, mais on y a représenté en plus la circulation de lignes de courant et de champ électrique pour que cette figure puisse servir de support à l'exposé théorique suivant du fonctionnement de la structure selon la présente invention. Cet exposé théorique est donné uniquement à titre explicatif pour aider le lecteur à mieux comprendre et généraliser la présente invention. Néanmoins, toute erreur ou omission dans cet exposé théorique ne saurait affecter la validité de la présente invention dont les résultats ont été constatés expérimentalement par la demanderesse comme cela sera exposé ci-après.

Dans la figure, on a représenté en trait plein le courant de conduction dans le substrat résultant de porteurs majoritaires (trous), et en pointillé, le courant de diffusion des porteurs minoritaires (électrons), étant entendu que les électrons se propagent dans la direction inverse du sens désigné par les flèches sur la figure qui correspond à la représentation conventionelle de circulation du courant. Dans la figure 5, on a représenté par le symbole classique de la masse le potentiel le plus négatif de la source d'alimentation.

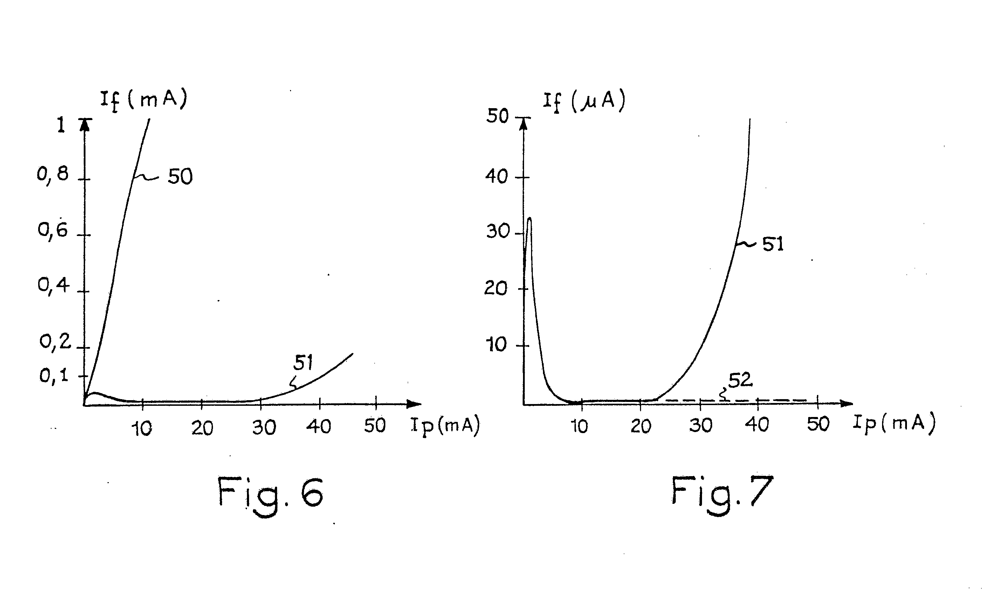

Quand une tension plus négative que le potentiel de référence, à savoir la masse dans l'exemple représenté, est appliquée sur le caissons 3, des électrons sont injectés en-dessous de ce caisson dans le substrat 1 et diffusent radialement comme indiqué par les traits en pointillé. Ces électrons sont collectés par le caisson annulaire 6 et le courant se referme vers la masse en passant par la métallisation 31, le mur 30, à nouveau le substrat 1, le mur 20 intermédiaire entre le caisson annulaire 6 et le caisson 3, et la métallisation 21. Il passe donc dans le substrat 1 deux courants en sens inverses: un courant 40 dirigé vers le caisson 3 et correspondant à la diffusion des électrons et un courant 41 dirigé vers l'extérieur par rapport au caisson 3 et correspondant à la conduction entre les murs 20 et 30. Il est important de noter que le courant 41 résulte du courant 40 et est sensiblement proportionnel à ce courant 40 ou courant parasite. Ce courant 41 engendre dans le substrat 1, qui a une résistivité donnée, un champ électrique E radial orienté vers l'extérieur du caisson 3 et ayant également une intensité à peu près proportionnelle au courant parasite 40 dont il résulte. Ainsi, les électrons en excès sous le caisson 3 ne peuvent pas traverser la barrière de potentiel établie par ce champ électrique E et se recombinent sur place. Le courant de recombinaison (non représenté en figure 5) est fourni au substrat par la métallisation 21 et le mur 20. En d'autres termes, le courant parasite générateur d'électrons dans le substrat crée un champ électrique servant au confinement de ces électrons et produit son propre remède. On obtient ainsi une correction proportionnelle à l'importance du courant résultant des tensions parasites. La qualité de cette compensation va être illustrée en relation avec les diagrammes des figures 6 et 7 suivantes.

Dans les figures 6 et 7, correspondant à des oscillogrammes relevés par l'inventeur, les ordonnées indiquent la somme des courants de fuite $I_f$ dans les caissons à protéger tels que les caissons 4 de la figure 2 alors que les abscisses indiquent le courant parasite $I_p$ injecté dans le caisson parasité tel que le caisson 3 de la figure 2. Les abscisses sont en mA et correspondent à une variation du courant $I_p$ de 0 à 50 mA et les ordonnées sont, pour la figure 6 en mA et s'étendent dans la gamme de 0 à 1 mA et pour la figure 7 en $\mu$A et s'étendent dans la gamme de 0 à 50 $\mu$A.

En figure 6, la courbe 50 correspond aux structures de l'art antérieur telles qu'illustrées en figure 3 et la courbe 51 correspond à une structure selon la présente invention telle qu'illustrée en figures 4 et 5. La figure 6 montre bien que, pour une structure selon l'art antérieur, on atteint un courant de fuite de l'ordre du mA pour l'ensemble des transistors à protéger dès que le courant injecté atteint une valeur de l'ordre de 10 mA, c'est-à-dire que seulement les 9/10e du courant injecté sont absorbés par le caisson annulaire. Par contre, comme le montre la courbe 51, la structure selon la présente invention permet d'obtenir des courants de fuite dans les caissons 4 à protéger inférieurs à quelques dizaines de $\mu$A dans une gamme allant de 0 à 30 mA pour le courant injecté, cette somme des courants de fuite étant même inférieure au $\mu$A pour des valeurs du courant injecté comprises entre environ 10 et 30 mA.

La courbe 51 est reprise en figure 7 avec une échelle dilatée en ordonnées. Pour éviter la croissance du courant (qui reste toutefois bien inférieure à celle des structures de l'art antérieur), pour des valeur injectées du courant parasite supérieures à 30 mA, c'est-à-dire pour de fortes tensions parasites négatives appliquées, il est prévu selon la présente invention de relier la métallisation 31 (voir figure 4) à une métallisation solidaire du substrat 1 et plus particulièrement de la face inférieure de ce substrat. La courbe 51, se prolonge alors par la courbe en pointillé désignée par la référence 52 en figure 7 et le dispositif conserve toute son efficacité contre des courants injectés pouvant être supérieurs à 100 mA. On peut estimer que la raison théorique de cette compensation est liée au fait que la croissance des courants de fuite pour des valeurs du courant injecté supérieures à 30 mA est liée à la chute de tension due à la résistance interposée entre la masse et la jonction entre le substrat 1 et le caisson 6. Cette résistance est égale à la somme de la résistance du substrat entre les murs d'isolement 20 et 30, de la résistance du mur 20, de celle du mur 30 et de celle du caisson 6. Si la chute de tension de cette résistance atteint un seuil de diode (environ 0,8 volt), la jonction substrat 1, caisson 6 devient polarisée dans le sens direct et injecte les électrons supplémentaires dans le substrat. La connexion indiquée plus haut entre la métallisation 31 et le substrat permet d'éviter cette injection.

La présente invention a été exposée précédemment dans le cas d'un circuit intégré monolithique élaboré sur un substrat de type P. Si le circuit intégré bipolaire était élaboré sur un substrat de type N, tout ce qui a été dit précédemment resterait valable en inversant tous les types de conductivité ainsi que les sens des courants. Notamment, la tension de référence de la source d'alimentation qui était la tension la plus négative dans l'exemple décrit précédemment serait la tension la plus positive.

D'autre part, si le caisson 6 doit bien entourer complètement le caisson parasité, par contre les métallisations 21 et 31 peuvent être interrompues sur une portion de leur périmètre pour laisser le passage à d'autres métallisations de connexion dirigées vers le composant inclus dans le caisson 3, ce qui évite d'avoir recours à des superpositions de métallisation. En outre, si des composants situés dans certains caissons 4 sont particulièrement sensibles aux courants de fuite, en raison par exemple du courant très faible avec lequel ils doivent fonctionner, il est évidemment avantageux d'éloigner ces composants du caisson parasité, mais, de plus, selon une caractéristique de la présente invention, on reliera les murs d'isolement entourant les caissons contenant ces composants au mur 30 et au caisson 6 en prolongeant de façon appropriée la métallisation 31; il en résulte une protection encore améliorée de ces caissons.

La présente invention pourra s'appliquer à tous les circuits intégrés qui, de par leur environnement, sont susceptibles de recevoir des surtensions parasites importantes, notamment en électronique industrielle et automobile.

La présente invention n'est pas limitée aux exemples de réalisation décrits précédemment. Elle en comprend les diverses variantes et généralisations incluses dans le domaine des revendications ci-après.

## Revendications

1. Dispositif de protection contre les courants de fuite dans des circuits intégrés monolithiques alimentés par une tension d'alimentation ayant un potentiel de référence, comprenant un substrat semiconducteur d'un premier type de conductivité revêtu d'une couche de deuxième type de conductivité dans laquelle sont formés divers composants élémentaires selon des caissons isolés les uns des autres par des murs d'isolement du premier type de conductivité rejoignant le substrat, dans lequel l'un des caissons (caisson parasité) est susceptible d'être soumis à des tensions parasites de polarité propre à rendre passante la jonction entre le caisson et le substrat, ce caisson étant entouré d'un caisson annulaire, caractérisé en ce que:

— le mur d'isolement (20) du caisson parasité (3) est connecté au potentiel de référence de la tension d'alimentation; et
— le caisson annulaire (6) est connecté à son mur d'isolement externe (30).

2. Dispositif selon la revendication 1, caractérisé en ce que le substrat (1) est de type P et les murs d'isolement de type P+; la couche comprenant les caissons est une couche épitaxiée de type N; et le potentiel de référence est le potentiel le plus négatif de la source d'alimentation.

3. Dispositif selon la revendication 1, caractérisé en ce que la connexion entre le caisson annulaire et son mur d'isolement externe est assurée par une métallisation annulaire (31) à cheval sur la jonction entre le caisson annulaire (6) et le mur d'isolement (30).

4. Dispositif selon la revendication 3, caractérisé en ce que ladite métallisation annulaire est interrompue sur une partie de son périmètre.

5. Dispositif selon la revendication 3, caractérisé en ce que ladite métallisation annulaire est prolongée pour contacter les murs d'isolement de certains caissons choisis.

6. Dispositif selon la revendication 3, caractérisé en ce que, sous chaque métallisation et portion de métallisation, est prévu un surdopage des couches sous-jacentes, selon le type de conductivité de ces couches, pour assurer une bonne ohmicité des contacts.

7. Dispositif selon la revendication 3, caractérisé en ce que la métallisation annulaire est en outre connectée à une métallisation du circuit intégré en contact ohmique avec la face inférieure du substrat.

8. Dispositif selon l'une quelconque des revendications 1 à 7, caractérisé en ce qu'une couche enterrée du second type de conductivité et à niveau de dopage élevé est disposée à l'interface entre le fond de chaque caisson et le substrat.

9. Circuit intégré, caractérisé en ce qu'il comprend un dispositif selon l'une quelconque des revendications 1 à 8.

## Patentansprüche

1. Vorrichtung zum Schutz gegen Leckströme in integrierten monolithischen Schaltungen, die durch eine Versorgungsspannung mit einem Referenzpotential versorgt werden, mit einem Halbleitersubstrat eines ersten Leitungstyps, das von einer Schicht des zweiten Leitungstyps bedeckt ist, in der verschiedene Elementarbauteile gemäß Kästen gebildet sind, die voneinander durch Isolierwände des ersten Leitungstyps isoliert sind, welche bis an das Substrat heranreichen, wobei einer der Kästen (gestörter Kasten) Störspannungen ausgesetzt werden kann, deren Polarität geeignet ist, den Übergang zwischen dem Kasten und dem Substrat leitfähig zu machen, wobei dieser Kasten umgeben ist von einem ringförmigen Kasten, dadurch gekennzeichnet, daß:

— die Isolierwand (20) des gestörten Kastens (3) an das Bezugspotential der Versorgungsspannung angeschlossen ist; und
— der ringförmige Kasten (6) an seiner äußeren Isolierwand (30) angeschlossen ist.

2. Vorrichtung nach Anspruch 1, dadurch gekennzeichnet, daß das Substrat (1) vom P-Typ ist und die Isolierwände vom P+-Typ sind; wobei die die Kästen enthaltende Schicht eine epitaktische Schicht vom N-Typ ist; und wobei das Bezugspotential das am stärksten negative Potential der Versorgungsquelle ist.

3. Vorrichtung nach Anspruch 1, dadurch gekennzeichnet, daß die Verbindung zwischen dem ringförmigen Kasten und seiner äußeren Isolierwand durch eine ringförmige Metallisierung (31) gewährleistet ist, die rittlings über dem Übergang zwischen dem ringförmigen Kasten (6) und der Isolierwand (30) angeordnet ist.

4. Vorrichtung nach Anspruch 3, dadurch gekennzeichnet, daß die genannte ringförmige Metallisierung auf einem Teil ihres Umfangs unterbrochen ist.

5. Vorrichtung nach Anspruch 3, dadurch gekennzeichnet, daß die ringförmige Metallisierung verlängert ist, um die Isolierwände bestimmter ausgewählter Kästen zu kontaktieren.

6. Vorrichtung nach Anspruch 3, dadurch gekennzeichnet, daß unter jeder Metallisierung und jedem Metallisierungsteil eine Überdotierung der darunterliegenden Schichten mit dem Leitungstyp dieser Schichten vorgesehen ist, um eine gute ohmsche Leitfähigkeit der Kontakte zu gewährleisten.

7. Vorrichtung nach Anspruch 3, dadurch gekennzeichnet, daß die ringförmige Metallisierung ferner an eine Metallisierung der integrierten Schaltung angeschlossen ist, die in ohmschem Kontakt mit der unteren Fläche des Substrats ist.

8. Vorrichtung nach einem der Ansprüche 1 bis 7, dadurch gekennzeichnet, daß eine vergrabene Schicht des zweiten Leitungstyps und mit hohem Dotierungsgrad an der Grenze zwischen dem Boden jedes Kastens und dem Substrat angeordnet ist.

9. Integrierte Schaltung, dadurch gekennzeichnet, daß sie eine Vorrichtung nach einem der Ansprüche 1 bis 8 enthält.

**Claims**

1. Device for protection against leakage currents in integrated monolithic circuits supplied by a supply voltage having a reference potential, comprising a semiconductor substrate of a first conductivity type covered with a layer of the second conductivity type in which various elementary components are formed along cases insulated from each other by insulating walls of the first conductivity type and joining the substrate, wherein one of the cases (disturbed case) is susceptible to be subjected to parasitic voltages of polarities adapted to render conductive the junction between the case and the substrate, said case being surrounded by an annular case, characterized in that:

— the insulation wall (20) of the disturbed case (3) is connected to the reference potential of the supply voltage; and
— the annular case (6) is connected to its external insulation wall (30).

2. Device in accordance with claims 1, characterized in that the substrate (1) is of P type and the insulation walls of P+ type; the layer comprising cases and an epitaxial layer of N type; and the reference potential being the most negative potential of the supply source.

3. Device in accordance with claim 1, characterized in that the connection between the annular case and its external insulation wall is assured by an annular metallization (31) straddling the junction between the annular case (6) and the insulation wall (30).

4. Device in accordance with claim 3, characterized in that said annular metallization is interrupted at a portion of its periphery.

5. Device in accordance with claim 3, characterized in that said annular metallization is extended for contacting the insulation walls of certain selected cases.

6. Device in accordance with claim 3, characterized in that beneath each metallization and metallization protion the underlying layers are high-doped in accordance with the conductivity type of these layers in order to assure a good ohmic conductivity of the contacts.

7. Device in accordance with claim 3, characterized in that the annular metallization is further connected with a metallization of the integrated circuit which is in ohmic contact with the lower face of the substrate.

8. Device in accordance with any of claims 1 to 7, characterized in that a buried layer of the second conductivity type and of high doping level is located at the interface between the bottom of each case and the substrate.

9. Integrated circuit, characterized in that it comprises a device in accordance with any of claims 1 to 8.

Fig.1

Fig.2

Fig.3

Fig.4

Fig.5

0 040 125

Fig. 6

Fig. 7